# EUROPEAN PATENT APPLICATION

(11) **EP 4 332 052 A1**
(43) Date of publication of application: **06.03.2024**
(21) Application number: 22193252.8
(22) Date of filing: 31.08.2022
(51) Int. Cl.: B81B 3/00, H04R 31/00, H04R 19/00

(54) **ENCAPSULATED MEMS DEVICE AND METHOD FOR MANUFACTURING THE MEMS DEVICE**

(71) Applicant: Infineon Technologies AG, 85579 Neubiberg (DE)
(72) Inventor: STREB, Fabian, 93059 Regensburg (DE); STRASSER, Johann, 84069 Schierling (DE); TIMME, Hans-Joerg, 85521 Ottobrunn (DE); FUELDNER, Marc, 85579 Neubiberg (DE); WALTHER, Arnaud, 82008 Unterhaching (DE); WASISTO, Hutomo Suryo, 81541 München (DE)
(74) Representative: Stöckeler, Ferdinand

(57) **Abstract**

An encapsulated MEMS device and a method for manufacturing the MEMS device are provided. The method comprises providing a cavity structure having an inner volume comprising a plurality of MEMS elements, which are relatively displaceable with respect to each other, and having an opening structure to the inner volume, depositing a Self-Assembled Monolayer (SAM) through the opening structure onto exposed surfaces within the inner volume of the cavity structure, and closing the cavity structure by applying a layer structure on the opening structure for providing a hermetically closed cavity.

## Description

### Technical field

Embodiments of the present disclosure relate to a MEMS (micro-electro-mechanical system) device, such as an encapsulated MEMS device comprising a cavity structure with a Self-Assembled Monolayer. In particular, embodiments relate to an apparatus and a method for with a cavity structure coated with a Self-Assembled Monolayer (SAM).

### Background

Microelectromechanical systems (MEMS) devices such as sensors and/or actuators may include MEMS elements that are displaceable relative to each other. In many cases, such moving MEMS elements may be encapsulated in a cavity structure in order to provide a space (volume) for their required movements, and/or a specific atmosphere and pressure or even vacuum for enabling a proper function e.g. with respect to damping, long-term stability, or containment of a specific gas environment (e.g., a CO₂ sensing reference).

During manufacturing, care should be taken in order to reduce a risk of sticking of such movable MEMS elements during a release process. This risk can be reduced by a proper design of the underlying production process. However, another issue is how to prevent potential sticking of the movable MEMS elements during a later use of such MEMS products.

Another type of sticking may occur during the operation of MEMS devices, often in the form of non-permanent or soft sticking. One way to reduce this kind of sticking is the use of small bump structures, which provide only a very small contact area between MEMS elements which might stick otherwise. Usually, the smaller the size of such bumps (and therefore their contact areas) are, the better the sticking protection is. However, very small or sharp bumps are difficult to fabricate and may cause damage to structures in case of severe contact forces, for example.

Whereas sticking can be avoided during normal operating conditions of the MEMS devices by proper design of the MEMS device, harsh conditions like e.g. in stress tests or drop tests may lead to a contact of the movable MEMS elements with walls of their surrounding cavity or other MEMES elements. For a more sensitive movable MEMS element it may be more likely that such contact situations occur even during normal usage of an end product.

Therefore, there is need for a MEMS device and a method for manufacturing device that addresses one or more of these needs.

Such a need can be solved by the method for manufacturing an encapsulated MEMS device according to independent claim 1 and the encapsulated MEMS device according to the independent claim 14.

Further, specific implementations of the MEMS device are defined in the dependent claims.

### Summary

According to an embodiment, a method for manufacturing an encapsulated MEMS device is provided. The method comprises providing a cavity structure having an inner volume comprising a plurality of MEMS elements, which are relatively displaceable with respect to each other, and having an opening structure to the inner volume. The method further comprises depositing a Self-Assembled Monolayer (SAM) through the opening structure onto exposed surfaces within the inner volume of the cavity structure. The method comprises closing the cavity structure by applying a layer structure on the opening structure for providing a hermetically closed cavity.

According to a further embodiment, an encapsulated MEMS device is provided. The MEMS device comprises a cavity structure having an inner volume comprising a plurality of MEMS elements, which are displaceable with respect to each other, and having an opening structure to the inner volume. The MEMS device further comprises a Self-Assembled Monolayer (SAM) deposited onto exposed surfaces within the inner volume of the cavity structure and a closing structure on the opening structure for hermetically closing the cavity structure.

Thus, according to an embodiment, the cavity structure allows having a different pressure compared to ambient pressure (e.g., a vacuum in the mbar or µbar regime), wherein a displacement of the MEMS elements that benefit from the atmosphere inside the cavity structure (e.g., less dampening of displacement due to a vacuum) has a lower risk of sticking in the event of abutment against another MEMS element and/or inner surfaces of the cavity structure.

### Brief Description of the Figures

In the following, embodiments of the present disclosure are described in more detail with respect to the figures, in which:
- Fig. 1: shows a schematic view of a cross section through an encapsulated MEMS device according to an embodiment;
- Fig. 2: shows a principal flow diagram for a method for manufacturing an encapsulated MEMS device according to an embodiment;
- Fig. 3A: shows an example of a layer arrangement on a carrier substrate;
- Fig. 3B: shows the layer arrangement of Fig. 3A after the removal of a sacrificial material;
- Fig. 4A: shows another example of the layer arrangement with additional MEMS elements;
- Fig. 4B: shows a MEMS device manufactured by depositing a Self-Assembled Monolayer and closing a cavity structure according to an embodiment;
- Fig. 5A: shows a perspective top view of a first membrane structure with an opening structure comprising symmetrically arranged openings according to an embodiment; and
- Fig. 5B: shows a perspective top view of the first membrane structure with an opening structure comprising asymmetrically arranged openings according to an embodiment.

In the following description, embodiments are discussed in further detail using the figures, wherein in the figures and the specification identical elements and elements having the same functionality and/or the same technical or physical effect are provided with the same reference numbers or are identified with the same name. Thus, the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of semiconductor devices. The specific embodiments discussed are merely illustrative of specific ways to make and use the present concept, and do not limit the scope of the embodiments. In the following description of embodiments, the same or similar elements having the same function have associated therewith the same reference signs or the same name, and a description of such elements will not be repeated for every embodiment. Moreover, features of the different embodiments described hereinafter may be combined with each other, unless specifically noted otherwise.

In the description of the embodiments, terms and text passages placed in brackets are to be understood as further explanations, exemplary configurations, exemplary additions and/or exemplary alternatives,

It is understood that when an element is referred to as being "connected" or "coupled" to another element, it may be directly connected or coupled to the other element, or intermediate elements that may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, some of the figures comprise a Cartesian coordinate system x, y, z, wherein the x-y-plane corresponds, i.e. is parallel, to a main surface region (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction or a direction parallel to (or in) the x-y-plane, wherein the term "vertical" means a direction parallel to the z-direction.

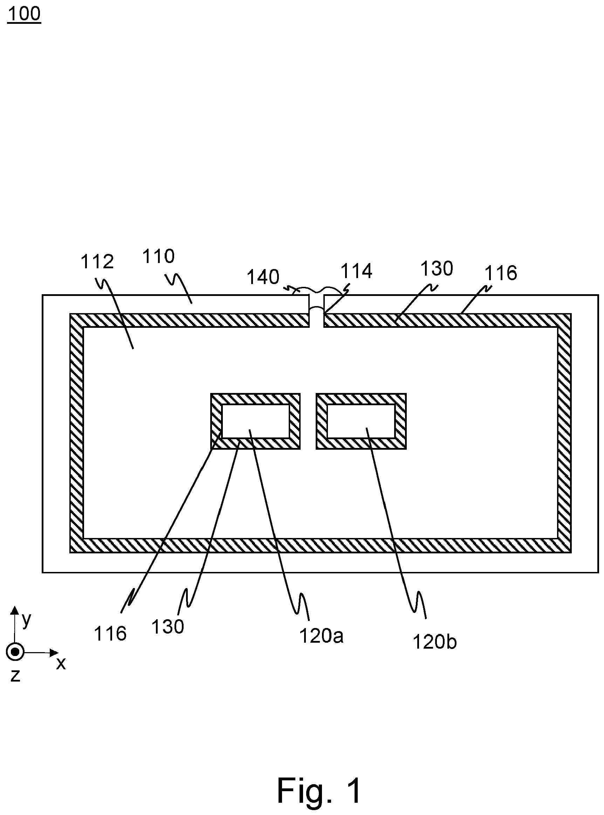

Fig. 1 shows a schematic view of a cross section through an encapsulated MEMS device 100 according to an embodiment.

The MEMS device 100 comprises a cavity structure 110 having an inner volume 112 comprising a plurality of MEMS elements 120a, b, which are relatively displaceable with respect to each other, and having an opening structure 114 to the inner volume 112. The MEMS device 100 further comprises a Self-Assembled Monolayer (SAM) 130 deposited onto exposed surfaces 116 within the inner volume 112 of the cavity structure 110. The MEMS device 100 comprises a closing structure 140 on the opening structure 114 for hermetically closing the cavity structure 110.

The SAM layer 130 coats the exposed surfaces 116 and can offer lower surface energies, which reduces the risk of the surfaces 116 sticking to each other when they get in contact. Unsticking of a contact requires that the restoring force of the displaceable (e.g., movable) MEMS structure (e.g. a cantilever structure or a membrane structure) is larger than the adhesion force F. Adhesion forces like e.g. Van der Waals forces depend on the contact distance D and on the contact area, but also on the geometry of the contact partners and on their respective material(s). More precisely, the adhesion force F = -dW/dD depends on the work of adhesion W, which equals twice the negative surface energy y of the material, i.e. W = - 2*γ. The surface energy of the exposed surfaces 116 (e.g., of the MEMS elements 120 and/or the cavity structure 110) can be influenced/engineered by very thin films - even by a monolayer - adsorbed on the respective contact material(s) (e.g., exposed surfaces 116). A variety of so-called Self-Assembly Monolayers (SAMs) can offer (among other properties) very low surface energies (see examples mentioned below).

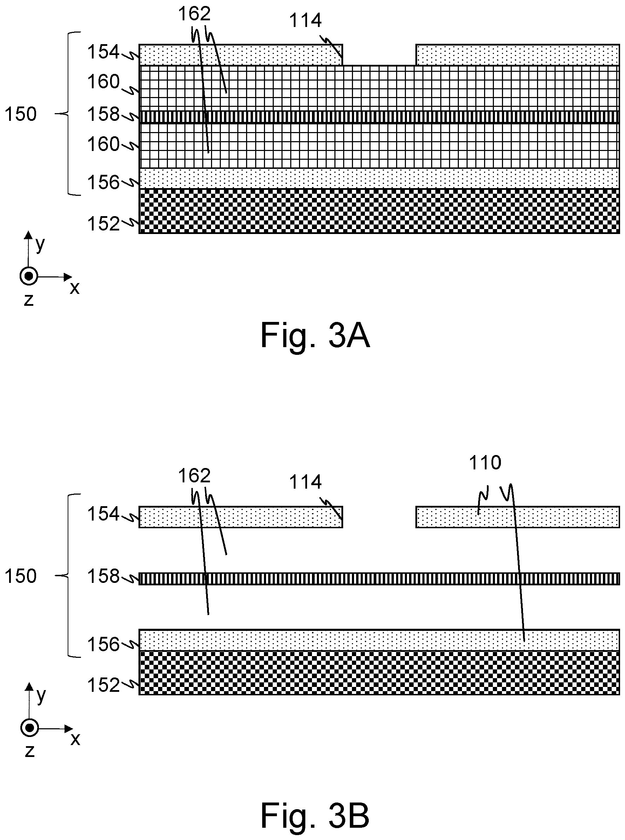

The cavity structure 110 shown in Fig. 1 is a rectangular cuboid (e.g., an oblong cuboid). As a result, the inner volume 112 is also a cuboid. However, the cavity structure 110 and/or the inner volume 112 may have any other shape (e.g., a cylinder, a sphere, a cone, a prism, a pyramid, or a truncated and/or warped version of any of these examples). For example, the cavity structure may be provided between two spaced apart membrane structure (e.g., forming a cylinder like shape), as will be described in more detail with reference to Figs. 3A to 4B.

The MEMS device 100 may comprise two, three, four, five, or more MEMS elements 120. In Fig. 1, the MEMS elements 120a, 120b are schematically indicated as rectangles. However, the MEMS elements 120 may comprise at least one of a membrane structure, a cantilever structure, an anti-sticking bump (e.g., a confining structure relative to which a deflectable structure like a membrane structure or cantilever structure is deflectable, wherein the confining structure limits deflection of the deflectable structure, e.g., by abutting against the deflected deflectable structure), a strut, a stator (e.g., a structure that is part of or fixedly arranged relative to the cavity structure 110), a piezo-electric element, and a gear. The MEMS elements 120 depicted in Fig. 1 are formed separate from the cavity structure 110. However, at least one of the MEMS 120 elements may be connected or integrally formed with the cavity structure 110. For example, a membrane structure or cantilever structure may be attached to or integrally formed with the cavity structure 110, wherein a counter electrode structure may be formed within the cavity structure 110. Such a MEMS device 100 may be formed as a sealed dual membrane (SDM) sound-transducer (microphone or loudspeaker).

The exposed surfaces 116 may comprise at least a part of (inner) surfaces of the cavity structure 110 and surfaces of the MEMS elements 120. For examples, the entire inner surface of the cavity structure 110 may be part of the exposed surface 116. An inner surface of the closing structure 140 may not be part of the exposed surfaces 116 (e.g., an inner surface of the closing structure 140, because a coating process of the SAM layer 130 was finished before the closing structure 140 hermetically closed the cavity structure 110) or may be part of the exposed surfaces 116 (e.g., because after closing the cavity structure 110 residual material formed a SAM layer 130 on the inner surface of the closing structure 140).

At least two of the MEMS elements 120 may be arranged (e.g., relative to each other) such that displacement (e.g., at least one of vibration, translation, actuation, rotation, compression, and expansion) of at least one of the two MEMS elements 120 may cause physical contact between each other and/or the cavity structure 110. Physical contact may be caused by displacement beyond a threshold level (e.g., displacement of a membrane caused by a threshold sound intensity or displacement due to external acceleration such as during a drop test).

The opening structure 114 shown in Fig. 1 comprises an opening in a wall of the cavity structure 110. The opening may have surfaces that extend in parallel or that form a conical shaft. The opening may be circular or rectangular. The opening structure may be formed by a missing or removed side wall of the cavity structure 110. The opening structure may be formed in a wall (as shown in Fig. 1), in an edge between two side walls or a corner of three or more side walls.

The closing structure 140 may be or comprise a material (e.g., a layer structure) deposited over the opening structure 114 (e.g. as exemplarily depicted in Fig. 1). The closing structure 140 may comprise (or consist of) material for closing the opening structure 140, which may comprise at least one of a nitride material, oxide material and an epitaxial poly-silicon material. At least a part of or the entire closing structure 140 may be deposited by at least one of a chemical vapor deposition (CDP), high density plasma chemical vapor deposition (HDPCVD), plasma-enhanced chemical vapor deposition (PECVD), and low pressure chemical vapor deposition (LPCVD) process.

The closing structure 140 may form a local closure element comprising a layer sequence with a CVD layer and an HDPCVD layer. The closing structure 140 may be formed according to method steps disclosed further below.

The closing structure 140 may be configured to hermetically close the cavity structure 110 for an overpressure (inside the cavity structure 110 compared to outside of the cavity pressure) of up to 0.5bar, 1bar, or 5bar and/or for a (near) vacuum (inside the cavity pressure 110) equal or below 0.1bar, 10mbar, 1mbar, 100µbar, 10µbar or 1µbar (or within a range between any of these pressure values). The cavity structure 110 hermetically closed with the closing structure 140 may be pressurized with an overpressure of up to 0.5bar, 1bar, 5bar or 10bar or contain a (near) vacuum equal or below 0.1bar, 10mbar, 1mbar, 100µbar, 10µbar or 1µbar (or between any of these pressure values). According to an embodiment, the cavity structure 110 may comprise a reduced atmospheric pressure, e.g., a "vacuum" or near vacuum with an atmospheric pressure of about or below 100 Torr, 50 Torr, 5 Torr or 1 Torr, or between 100 Torr and 1 Torr or between 50 Torr and 1 Torr (with 1 Bar = 750, 062 Torr).

Additionally or alternatively, the cavity structure 110 may be filled with a gas that comprises at least one of carbon dioxide (CO₂), carbon monoxide (CO), nitrogen oxide (NₓO_{y}), and ozone (O₃).

The SAM layer 130 may comprise (or consist of) at least one of Perfluorodecyltrichlorosilane (FDTS), Heptadecafluoro-1,1,2,2- tetrahydrodecyltrichlorosilane (HDFS), Tridecafluoro-1,1,2,2-tetrahydrooctyltrichlorosilane (FOTS), Octadecyltrichlorsilane (ODTS), Methyltrimethoxysilane (MTMS), Bis(trimethylsilyl)amine or hexamethyldisilazane (HMDS), (3-Aminopropyl)triethoxysilane (APTES), Dichlorodimethylsilane (DDMS), Octadecyltrimethoxysilane (OTMS), Noctadecyltrimethoxysilane (ODS), Dimethyl(dimethylamino)silane (DMAS), and Ethyltriethoxysilane (ETES), and 1H,1H,2H,2H-perfluorooctyltriethoxysilane (HFOTES).

Such self-assembled monolayers (SAMs) are commonly deposited as a last (final) layer onto a surface of MEMS devices at the end of a semiconductor process before pre-assembly and/or packaging.

Fluorocarbon coatings such as FDTS, FOTS, and HFOTES exhibit good stability at high temperatures. A particularly preferred candidate is FDTS, which provides an excellent temperature stability of 400°C and above. For protecting on-chip encapsulated MEMS structures (e.g., MEMS elements 120) from sticking, the SAM layer 130 is preferably integrated into a production process of the MEMS devices, i.e. before a sealing process of the (on-chip) cavity structure 110 with the closing structure 140. A SAM material with high temperature stability (e.g., the fluorocarbon coatings and in particular FDTS) have a higher probability of withstanding and surviving subsequent process steps and process temperatures. For example such SAM layers 116 may be stable during a complementary metal-oxide-semiconductor (CMOS) process chain.

The MEMS device 100 can, for example, be used in all kinds of (e.g., on-chip encapsulated) moving MEMS application. The MEMS device 100 may be part of a sealed membrane microphone (e.g., with one, two, or more membrane structures). The microphone may comprise a chamber (e.g., a cavity structure 110) that is housing or at least partially formed by two or more membranes structures, wherein at least one of the membrane structures, a cantilever, an anti-sticking bump may be covered by the SAM layer 130 and consequently has a lower chance of sticking to other MEMS elements 120 of the microphone.

The MEMS device 100 (or a microphone comprising the MEMS device 100) may be a part of a gas sensor, for example, a photoacoustic gas sensor. The MEMS device 100 or the microphone can be used to detect acoustic waves indicative of a gas concentration inside a measuring cell.

The MEMS device 100 may be part of an (e.g., on-chip encapsulated) acceleration sensor. For example, the MEMS device 100 may comprise deflectable MEMS elements 120 (e.g., struts, trenches, membrane structures or cantilever structures) that are configured to be deflected upon acceleration of the acceleration sensor, wherein detected deflection (e.g., detected capacitively between two or more struts or membrane structures) may be indicative of the acceleration.

The MEMS device 100 may be part of an angular rate sensor. The angular rate sensor may comprise deflectable MEMS elements 120 that are deflectable by rotation (or a change of rotation rate) of the angular rate sensor. The deflection may be detected capacitively between the deflected MEMS elements 120.

The MEMS device 100 may be part of a MEMS mirror. The MEMS mirror may comprise actuators (e.g., piezoelectric elements), which may at least partially be MEMS elements 120 arranged within the cavity structure 110.

The MEMS device 100 may be part of a MEMS switch (e.g., a radio frequency MEMS switch). For example, the MEMS device 100 may comprise deflectable MEMS elements 120 in form relay structures of the MEMS switch.

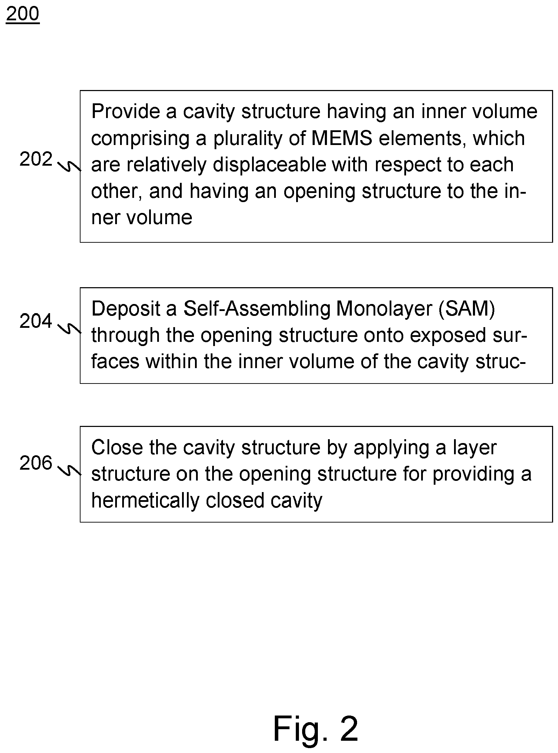

Fig. 2 shows a principal flow diagram 200 for a method for manufacturing an encapsulated MEMS device 100 as described herein.

The method comprises providing, in step 202, a cavity structure 110 having an inner volume 112 comprising a plurality of MEMS elements 120, which are relatively displaceable with respect to each other, and having an opening structure 114 to the inner volume 112.

The method comprises depositing, in step 204, a Self-Assembled Monolayer (SAM) 116 through the opening structure 114 onto exposed surfaces 116 within the inner volume 112 of the cavity structure 110.

The method further comprises closing, in step 206, the cavity structure 110 by applying a layer structure (e.g., closing structure 140) on the opening structure 114 for providing a hermetically closed cavity.

The method allows fabricating a MEMS device 100 as described herein (and exemplarily depicted in Fig. 1). Local X-ray photoelectron spectroscopy (XPS) spectroscopy can be used to detect certain materials (e.g., fluoride groups) of the SAM layer 130 and therefore allows determining whether the SAM layer 130 has formed in a desired way.

The step 204 of depositing the Self-Assembled Monolayer (SAM) may comprise a molecular vapor deposition process. For example, the molecular vapor deposition process may comprise placing the cavity structure 110 in a heated chamber (e.g., 0.2mbar) together with precursors such that inside the chamber a saturated atmosphere comprising of coating molecules forms, wherein the coating molecules react on at least a part of the exposed surfaces 116, forming the SAM layer 130. However, the Self-Assembled Monolayer (SAM) may be deposited using different procedures such as a wet process (e.g., immersion of the cavity structure 110 into a liquid comprising material that forms the SAM layer during and/or after immersion in the liquid.

A material for depositing the SAM layer comprises at least one of Perfluorodecyltrichlorosilane (FDTS), Heptadecafluoro-1,1,2,2- tetrahydrodecyltrichlorosilane (HDFS), Tridecafluoro-1,1,2,2-tetrahydrooctyltrichlorosilane (FOTS), Octadecyltrichlorsilane (ODTS), Methyltrimethoxysilane (MTMS), Bis(trimethylsilyl)amine or hexamethyldisilazane (HMDS), (3-Aminopropyl)triethoxysilane (APTES), Dichlorodimethylsilane (DDMS), Octadecyltrimethoxysilane (OTMS), Noctadecyltrimethoxysilane (ODS), Dimethyl(dimethylamino)silane (DMAS), Ethyltriethoxysilane (ETES), and 1H,1H,2H,2H-perfluorooctyltriethoxysilane (HFOTES).

The step 206 of closing the opening structure 114 may be performed with at least one of a chemical vapor deposition (CVD), high density plasma chemical vapor deposition (HDPCVD), plasma-enhanced chemical vapor deposition (PECVD), and low pressure chemical vapor deposition (LPCVD) process. The material for closing the opening structure 114 may comprise at least one of a nitride material, oxide material and an epitaxial poly-silicon material.

The following explanations relate by way of example to a method for closing the cavity structure 110, for example in the form of a vacuum microphone with a hermetically sealed double diaphragm configuration, but it should be noted that these embodiments are equally applicable to any devices or MEMS devices 100, at which at least one or a plurality of openings of the opening structure 114 are to be hermetically sealed in a reliable manner.

According to embodiments, a reliable, hermetic sealing of the one or more opening(s) of the opening structure 114 is achieved by means of a two-stage deposition process. At the first stage, a CVD deposition (CVD = Chemical Vapor Deposition) is performed in order to deposit a first cover layer with a first layer thickness onto an outer surface of the cavity structure 110 (at least in a vicinity of the one or more openings) and the opening or openings (e.g. onto a surface of a shaft of the one or more openings). For example, in CVD deposition, oxide material, such as a silicon oxide, or even a nitride material, such as a silicon nitride material, may be deposited on the outer surface of the cavity structure 110. At the second stage following the CVD deposition process for the first cover layer, HDPCVD (High Density Plasma Chemical Vapor Deposition) deposition is now also performed, this HDPCVD film deposition may be divided into two HDPCVD sub steps to form a second cover layer on the first cover layer.

Optionally, another cover or sealing layer, for example, of a silicon nitride material, may be applied with a further CVD process to provide yet another hermetic sealing layer at the top of the existing layer stack (e.g., comprising the first and second cover layer). Thereafter, the resulting cover layer stack (comprising the first and second cover layer and further optional layer(s)) applied to the cavity structure 110 and the openings therein may be structured, e.g., with a selective etching process, such that each opening of the opening structure 114 receives a single closure element (also: sealing plug) at each opening of the opening structure 114.

Since in the HDPCVD process, a high vacuum is present in the process area, a correspondingly high vacuum may be generated inside the cavity structure 110 (and also retained therein) in the process of hermetically sealing the one or more openings of the opening structure 114.

Thus, according to embodiments, the operation of closing the opening structure 114 can be performed under a high vacuum, so that a resulting high vacuum can be obtained in the cavity structure 110. The manufacturing process described herein, may manufacture a closing structure 114 that can be designed to withstand the typical environmental conditions for MEMS devices 100 with deflectable MEMS elements 120 such as in microphones during use in mobile applications without exhibiting malfunction or reduced performance. Furthermore, the hermetic seal can be reliably achieved even against moisture. Furthermore, the mechanical and electrical properties and functionalities of the resulting MEMS device, for example, a MEMS microphone or a MEMS sensor, is not or only slightly changed by the applied closing structure 140.

The method may comprise further steps after depositing the SAM layer (e.g., before the step of closing the opening structure 114). For example, the method may comprise at least one of annealing, a plasma treatment, a remote plasma treatment (e.g., reducing or oxidizing), an oxidizing plasma treatment, and a reducing plasma treatment. The plasma treatments (e.g., remote plasma) can be used to remove at least a part of the SAM layer 130 of a surface at the opening structure 114, which reduces the risk of the SAM layer 130 impairing the closing step. In other words, for the purpose of making sure the SAM layer 130 does not prevent the sealing of the cavity structure 112, specific cleaning steps (e.g., the plasma treatments described herein) can be used.

The method may further comprise conducting a surface treatment in form of a plasma oxidizing step of the surfaces 116 within the inner volume 112 of the cavity structure 110 before the deposition of the Self-Assembled Monolayer 130, and conducting a further surface treatment in form of a remote plasma step (reducing or oxidizing) of a surface of the cavity structure 110 at the opening structure 114 after the deposition of the Self-Assembled Monolayer 130. The plasma oxidizing step may terminate at least a portion of the exposed surface 116 (e.g., silicon) with OH groups. The OH groups may act as bonding site for the SAM layer 130.

In the following, an example of manufacturing steps with a first and second membrane structure are described.

The method may comprise providing a layer arrangement on a carrier substrate, wherein the layer arrangement has a first and a second membrane structure spaced apart from one another and a counter electrode structure arranged therebetween, wherein a sacrificial material is arranged in an intermediate region between the counter electrode structure and the first and second membrane structures, and wherein at least one of the first and second membrane structure has the opening structure to the intermediate region with the sacrificial material.

Fig. 3A shows an example of a layer arrangement 150 on a carrier substrate 152. The layer arrangement 150 has a first membrane structure 154 and a second membrane structure 156 spaced apart from another and a counter electrode structure 158 therebetween. The layer arrangement 150 further comprises a sacrificial material 160 that is arranged in an intermediate region 162 between the counter electrode structure 158 and the first and second membrane structures 154, 156. The first membrane structure 154 comprises the opening structure 114 to the intermediate region 162 with the sacrificial material 160.

It should be noted that the layer arrangement 150 may comprise more layers than shown in Fig. 3A. For example, the layer arrangement 150 may comprise a (e.g., sacrificial) spacer layer (or empty space) between the carrier substrate 152 and the second membrane structure 156. Furthermore, the layer arrangement may comprise additional membrane structures and/or counter electrode structures. At least one of the layers in the layer arrangement 150 (e.g., at least one of the first and second membrane structures 154, 156) may have a non-planar shape (e.g., a curved or corrugated shape).

The method may further comprise removing the sacrificial material 160 from the intermediate region 162 in order to obtain the cavity structure 110 between the first and second membrane structure 154, 156. The step of removing the sacrificial material may be performed by a process of wet etching, vapor etching, or dry etching the sacrificial material 160.

Fig. 3B shows the layer arrangement 150 of Fig. 3A after the removal of the sacrificial material 160. The first and second membrane structure 154, 156 as well as one or more walls therebetween (not shown in Figs. 3A, B) form (at least a part of) the cavity structure 110.

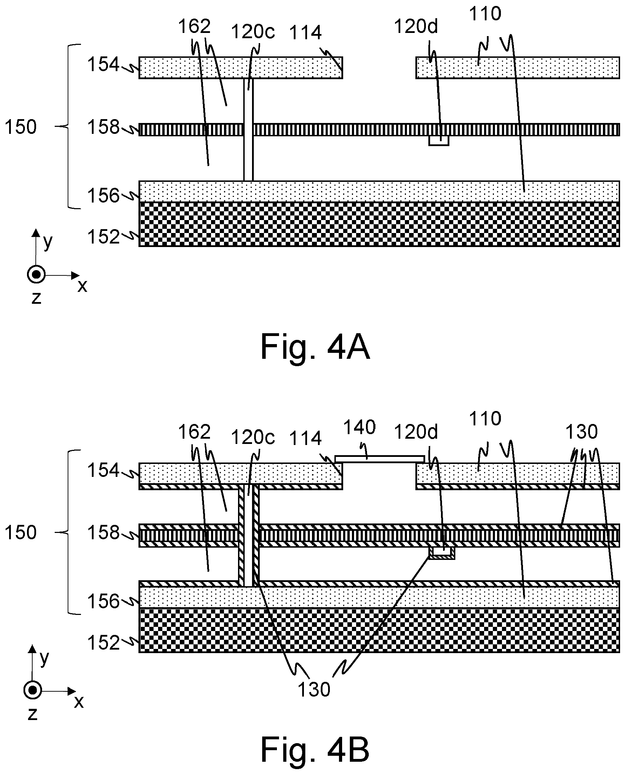

Fig. 4A shows another example of the layer arrangement 150 with additional MEMS elements 120c, d. The MEMS elements 120 may comprise a mechanical connection structure 120c (e.g., a pillar or column) that is mechanically coupled between the first and second membrane structure 154, 156 and is mechanically decoupled from the counter electrode structure 158 structure in the cavity structure 110 (e.g., the mechanical connection structure 120c may extend past or through an opening of the counter electrode structure 158). The MEMS elements 120 may comprise an anti-sticking bump 120d that is arranged on the counter electrode structure 158 (or spaced apart therefrom) movable relative to at least one of the first and second membrane structures 154, 156 (e.g., the anti-sticking bump 120d may be fixedly arranged on or relative to the counter-electrode 158 and/or a wall of the cavity structure 110).

The layer arrangement 150 with the mechanical connection structure 120c may be manufactured according to a method comprising the following steps. The method comprises providing a layer arrangement 150 on a carrier substrate 152, wherein the layer arrangement 150 comprises a second membrane structure 156, a sacrificial material 160 adjacent to the second membrane structure 156 and a counter electrode structure 158 within the sacrificial material 160 and spaced apart from the second membrane structure 156, wherein in the sacrificial material 160 at least one passage opening up to the second membrane structure 156 and separate from the counter electrode structure 158 is formed. The method may further comprise forming a filler structure in the passage opening by applying a first filling material layer on a wall area of the passage opening to an interior volume region in the passage opening. The method may comprise structurally applying a first membrane structure 154 on the layer arrangement 150 with the sacrificial material 160 and the filler structure in order hermetically close to the interior volume region, wherein the counter electrode structure 158 is arranged in an intermediate region filled with the sacrificial material and arranged between the first and second membrane structures 154, 156 and spaced apart from both. The method may further comprise removing the sacrificial material 160 in order to expose the filler structure in the intermediate area in order to obtain at least one mechanical connection structure 120c between the first and second membrane structures 154, 156, wherein the mechanical connection structure 120c is mechanically coupled between the first and second membrane structures 154, 156 and mechanically uncoupled from the counter electrode structure 158.

According to one embodiment, the step of removing the sacrificial material 160 is carried out by means of an isotropic etching process with a liquid or gaseous etching or reaction agent, wherein the etching agent has an etch rate that is at least a factor of ten higher for the sacrificial material 160 than for the first filling material (e.g., material comprised by the mechanical connection structure 120c).

According to one embodiment, before the step of providing the layer arrangement 150, the following steps for forming the layer arrangement 159 performed. The method may comprise forming the second membrane structure 156 in form of a first membrane layer or a first membrane layer stack on the carrier substrate 152. The method may further comprise depositing the sacrificial material 160 on the second membrane structure 156. The method may comprise forming the counter electrode structure 158 in form of a counter electrode layer or a counter electrode layer stack on the deposited sacrificial material 160. The method may comprise depositing sacrificial material 160 on the counter electrode structure 158. The method may comprise introducing the at least one passage opening into the sacrificial material 160 up to the second membrane structure 156 and separate from the counter electrode structure 158.

According to an embodiment, a plurality of passage holes are introduced in the sacrificial material 160 up to the second membrane structure 156, wherein the mechanical connection structure 120c are formed in the plurality of passage openings. The step of removing the sacrificial material exposes filler structure in the plurality of passage openings in order to obtain a plurality of mechanical connection structures 120c between the first and second membrane structures 154, 156, wherein the mechanical connection structures 120c are mechanically coupled between the first and second membrane structures 154, 156 and mechanically uncoupled from the counter electrode structure 158.

In one embodiment, the first and second membrane structures 154, 156 are further hermetically sealed under atmospheric vacuum or vacuum to create an atmospheric negative pressure or vacuum (e.g., described above) in the intermediate region between the first and second membrane structures 154, 156 of the dual-membrane MEMS device 100.

Acoustic MEMS sensors such as MEMS microphones are commonly formed as a stack of layers of silicon material, silicon nitride material, and silicon oxide material. The silicon material may, for example, comprise polycrystalline silicon (poly-silicon) or monocrystalline silicon. The materials described above are to be understood merely as an example, although semiconductor materials other than the described silicon material and insulating materials such other than the described nitride material and oxide material can be used, as far as the corresponding material properties can be obtained. To simplify the description herein, reference is made by way of example to silicon as semiconductor material and to nitride and oxide as insulating materials. As material for the sacrificial material can be used, for example, carbon, e.g. in the form of amorphous carbon.

For example, silicon oxide is often used as material for the sacrificial layer within a defined intermediate region and is etched out of such an intermediate region at the end of the manufacturing process of the MEMS microphone. For MEMS microphones with two membrane structures, e.g. silicon membrane structures, the two membrane structures can be mechanically coupled to each other by means of mechanical connection structures, which are also referred to as columns or connecting columns.

Fig. 4B shows a MEMS device 100 manufactured by depositing a Self-Assembled Monolayer 130 and closing the cavity structure 110 as described herein. In the example shown in Fig. 4B, the first and second membrane structures 154, 156, the counter electrode structure 158 and the MEMS elements 120c, d are at least partially coated with the SAM layer 130.

As a result, when the second membrane structure 156 is deflected and abuts against the anti-sticking bump 120d, the risk of a sticking between the second membrane structure 156 and the anti-sticking bump 120d is reduced. Similarly, the risk of a sticking between the mechanical connection structure 120c and the counter electrode structure 158 is reduced.

The examples shown in Figs. 3A-4B show an opening structure 114 only with a single opening (e.g. a through hole). However, the opening structure 114 may have a plurality of openings.

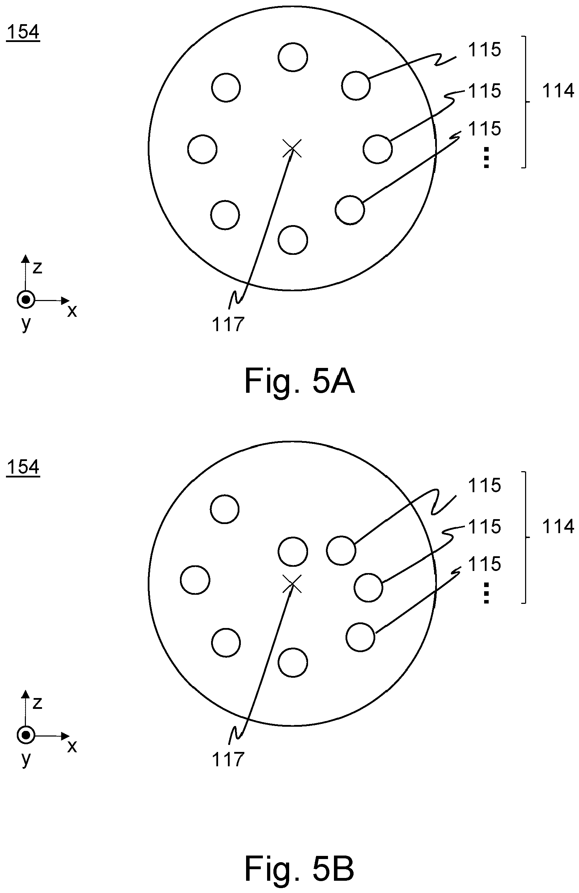

Fig. 5A shows a perspective top view of the first membrane structure 154 with an opening structure 114 comprising symmetrically arranged openings 115. It should be noted that the opening structure 114 may be arranged alternatively or additionally in other walls of the cavity structure 110 (e.g., the second membrane structure 156 and/or a wall connecting the first and second membrane structure 154, 156, e.g., at respective outer rims). The first membrane structure 154 depicted in Fig. 5A has an at least essentially circular shape. However, the membrane structure 154 may have any other shape (e.g., at least essentially the shape of an ellipsis, a square, an oblong rectangle, or a (e.g., regular) polygon). The first and second membrane structures 154, 156 may have similar (e.g. at least essentially congruent) shapes or different shapes.

The opening structure 114 depicted in Fig. 5A has eight openings 115 that are arranged symmetrically distributed around a geometric midpoint 117 of the first membrane structure 154. Alternatively, the opening structure 114 may have any other number of openings 115 such as two, three, four, five, or more. Furthermore, the openings 115 depicted in Fig. 5A are arranged at equal distances relative to the geometric midpoint 117. However, for at least one of the openings 115 the distance to the geometric midpoint 117 may differ. The distribution in Fig. 5A has a rotational symmetry. Alternatively or additionally, the distribution may have a mirror symmetry. A symmetrical distribution may result in a more even distribution of the SAM layer 130 and/or the closing structure 140, which may reduce an asymmetrical weight distribution of displaceable portions of the MEMS device (e.g., first and second membrane structure 154, 156).

Fig. 5B shows a perspective top view of the first membrane structure 154 with an opening structure 114 comprising asymmetrically arranged openings 115. An asymmetrical distribution may reduce the risk of emphasizing a specific oscillating mode and/or may at least partially compensate an asymmetrical weight distribution of the first and/or second membrane structure 154, 156. Furthermore, an asymmetrical distribution may result in a pattern of the SAM layer 130 that better covers exposed surfaces 116 that are more likely to contact another exposed surface 116.

Additional embodiments and aspects are described which may be used alone or in combination with the features and functionalities described herein.

According to an embodiment, a method for manufacturing an encapsulated MEMS device, comprises providing a cavity structure having an inner volume comprising a plurality of MEMS elements, which are relatively displaceable with respect to each other, and having an opening structure to the inner volume, depositing a Self-Assembled Monolayer (SAM) through the opening structure onto exposed surfaces within the inner volume of the cavity structure, and closing the cavity structure by applying a layer structure on the opening structure for providing a hermetically closed cavity.

According to an embodiment, the step of depositing the Self-Assembled Monolayer (SAM) comprises an molecular vapor deposition process.

According to an embodiment, a material for depositing the SAM layer comprises at least one of Perfluorodecyltrichlorosilane (FDTS), Heptadecafluoro-1,1,2,2- tetrahydrodecyltrichlorosilane (HDFS), Tridecafluoro-1,1,2,2-tetrahydrooctyltrichlorosilane (FOTS), Octadecyltrichlorsilane (ODTS), Methyltrimethoxysilane (MTMS), Bis(trimethylsilyl)amine or hexamethyldisilazane (HMDS), (3-Aminopropyl)triethoxysilane (APTES), Dichlorodimethylsilane (DDMS), Octadecyltrimethoxysilane (OTMS), Noctadecyltrimethoxysilane (ODS), Dimethyl(dimethylamino)silane (DMAS), Ethyltriethoxysilane (ETES), and 1H,1H,2H,2H-perfluorooctyltriethoxysilane (HFOTES).

According to an embodiment, the method further comprises conducting a surface treatment in form of a plasma oxidizing step of the surfaces within the inner volume of the cavity structure before the deposition of the Self-Assembled Monolayer, and conducting a further surface treatment in form of a remote plasma step (reducing or oxidizing) of a surface of the cavity structure at the opening structure after the deposition of the Self-Assembled Monolayer.

According to an embodiment, the SAM layer is applied to the inner surfaces of the cavity structure to provide a covalent bond of the Self-Assembled Monolayer to the material of the inner surface of the cavity structure.

According to an embodiment, the step of closing the opening structure is performed with a HDP, CVD, PECVD or LPCVD process.

According to an embodiment, the material for closing the opening structure comprises at least one of a nitride material, oxide material and an epitaxial poly-silicon material.

According to an embodiment, the step of providing a cavity structure comprises: providing a layer arrangement on a carrier substrate, wherein the layer arrangement has a first and a second membrane structure spaced apart from one another and a counter electrode structure arranged therebetween, wherein a sacrificial material is arranged in an intermediate region between the counter electrode structure and the first and second membrane structures, and wherein at least one of the first and second membrane structure has the opening structure to the intermediate region with the sacrificial material, and removing the sacrificial material from the intermediate region in order to obtain the cavity structure between the first and second membrane structure.

According to an embodiment, a mechanical connection structure (pillars / columns) is mechanically coupled between the first and second membrane structure and is mechanically decoupled from the counter electrode structure in the cavity structure.

According to an embodiment, the step of removing the sacrificial material is performed by a process of wet or vapor etching the sacrificial material.

According to an embodiment, the opening structure in at least one of the first and second membrane structures comprises a plurality of distributed openings (through-holes).

According to an embodiment, the (individual) openings of the opening structure are symmetrically distributed around a geometric midpoint of the first and/or second membrane structure, such as in a circular symmetry.

According to an embodiment, the openings of the opening structure are asymmetrically distributed around a geometric midpoint of the first and/or second membrane structure.

According to an embodiment, an encapsulated MEMS device comprises a cavity structure having an inner volume comprising a plurality of MEMS elements, which are displaceable with respect to each other, and having an opening structure to the inner volume, a Self-Assembled Monolayer (SAM) deposited onto exposed surfaces within the inner volume of the cavity structure, and a closing structure on the opening structure for hermetically closing the cavity structure.

According to an embodiment, the material for closing the opening structure comprises at least one of a nitride material, oxide material and an epitaxial poly-silicon material.

According to an embodiment, the encapsulated MEMS device is fabricated by means of the method described herein.

Although some aspects have been described as features in the context of an apparatus it is clear that such a description may also be regarded as a description of corresponding features of a method. Although some aspects have been described as features in the context of a method, it is clear that such a description may also be regarded as a description of corresponding features concerning the functionality of an apparatus.

Depending on certain implementation requirements, embodiments of the control circuitry can be implemented in hardware or in software or at least partially in hardware or at least partially in software. Generally, embodiments of the control circuitry can be implemented as a computer program product with a program code, the program code being operative for performing one of the methods when the computer program product runs on a computer. The program code may for example be stored on a machine readable carrier.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the claims and the equivalents thereof.

## Claims

1. A method (200) for manufacturing an encapsulated MEMS device (100), comprising:
Providing (202) a cavity structure (110) having an inner volume (112) comprising a plurality of MEMS elements (120), which are relatively displaceable with respect to each other, and having an opening structure (114) to the inner volume (112),
Depositing (204) a Self-Assembled Monolayer, SAM, (130) through the opening structure onto exposed surfaces within the inner volume of the cavity structure, and
Closing (206) the cavity structure (110) by applying a layer structure (140) on the opening structure (114) for providing a hermetically closed cavity.

2. The method of claim 1, wherein the step of depositing (204) the Self-Assembled Monolayer, SAM, (130) comprises a molecular vapor deposition process.

3. The method of claim 1 or 2, wherein a material for depositing the SAM layer (130) comprises at least one of
Perfluorodecyltrichlorosilane, FDTS,
Heptadecafluoro-1,1,2,2- tetrahydrodecyltrichlorosilane, HDFS,
Tridecafluoro-1,1,2,2-tetrahydrooctyltrichlorosilane, FOTS,
Octadecyltrichlorsilane, ODTS,
Methyltrimethoxysilane, MTMS,
Bis(trimethylsilyl)amine or hexamethyldisilazane, HMDS,
(3-Aminopropyl)triethoxysilane, APTES,
Dichlorodimethylsilane, DDMS,
Octadecyltrimethoxysilane, OTMS,
Noctadecyltrimethoxysilane, ODS,
Dimethyl(dimethylamino)silane, DMAS,
Ethyltriethoxysilane, ETES, and
1H,1H,2H,2H-perfluorooctyltriethoxysilane, HFOTES.

4. The method of any of the preceding claims, further comprising:
conducting a surface treatment in form of a plasma oxidizing step of the surfaces within the inner volume (112) of the cavity structure (110) before the deposition of the Self-Assembled Monolayer (130), and
conducting a further surface treatment in form of a remote plasma step of a surface of the cavity structure (110) at the opening structure (114) after the deposition of the Self-Assembled Monolayer (130).

5. The method of claim 4, wherein the SAM layer (130) is applied to the inner surfaces of the cavity structure (110) to provide a covalent bond of the Self-Assembled Monolayer (130) to the material of the inner surface of the cavity structure (110).

6. The method of any of the preceding claims, wherein the step of closing (206) the opening structure (110) is performed with a HDP, CVD, PECVD or LPCVD process.

7. The method of any of the preceding claims, wherein the material for closing the opening structure (114) comprises at least one of a nitride material, oxide material and an epitaxial poly-silicon material.

8. The method of any of the preceding claims, wherein the step of providing a cavity structure (110) comprises:
providing a layer arrangement (150) on a carrier substrate (152), wherein the layer arrangement (150) has a first and a second membrane structure (154, 156) spaced apart from one another and a counter electrode structure (158) arranged therebetween, wherein a sacrificial material (160) is arranged in an intermediate region between the counter electrode structure (158) and the first and second membrane structures, and wherein at least one of the first and second membrane structure (154, 156) has the opening structure (114) to the intermediate region with the sacrificial material (160), and
removing the sacrificial material (160) from the intermediate region in order to obtain the cavity structure (110) between the first and second membrane structure (154, 156).

9. The method of claim 8, wherein a mechanical connection structure (120c) is mechanically coupled between the first and second membrane structure (154, 156) and is mechanically decoupled from the counter electrode structure (158) in the cavity structure (110).

10. The method of claim 8 or 9, wherein the step of removing the sacrificial material (160) is performed by a process of wet or vapor etching the sacrificial material (160).

11. The method of any of claims 8 to 10, wherein the opening structure (114) in at least one of the first and second membrane structures (154, 156) comprises a plurality of distributed openings (115).

12. The method of claim 11, wherein the openings (115) of the opening structure (114) are symmetrically distributed around a geometric midpoint (117) of the first and/or second membrane structure (154, 156), such as in a circular symmetry.

13. The method of claim 11, wherein the openings (115) of the opening structure (114) are asymmetrically distributed around a geometric midpoint (117) of the first and/or second membrane structure (154, 156).

14. Encapsulated MEMS device (100), comprising:
a cavity structure (110) having an inner volume (112) comprising a plurality of MEMS elements (120), which are displaceable with respect to each other, and having an opening structure (114) to the inner volume (112),
a Self-Assembled Monolayer, SAM, (130) deposited onto exposed surfaces (116) within the inner volume (112) of the cavity structure (110), and
a closing structure (140) on the opening structure (114) for hermetically closing the cavity structure (110).

15. The MEMS device of claim 14, wherein the material for closing the opening structure (114) comprises at least one of a nitride material, oxide material and an epitaxial poly-silicon material.

16. The MEMS device of claim 14 or 15, wherein the encapsulated MEMS device (100) is fabricated by means of the method according to claims 1 to 12.
